(19) Europäisches Patentamt
European Patent Office
Office européen des brevets

(11) **EP 2 956 786 B1**

## (12) FASCICULE DE BREVET EUROPEEN

(45) Date de publication et mention de la délivrance du brevet:
**26.04.2017 Bulletin 2017/17**

(21) Numéro de dépôt: **14709993.1**

(22) Date de dépôt: **12.02.2014**

(51) Int Cl.:
*G01R 33/24* (2006.01)   *G01R 33/28* (2006.01)
*G01R 33/565* (2006.01)

(86) Numéro de dépôt international:
**PCT/FR2014/050276**

(87) Numéro de publication internationale:
**WO 2014/125214 (21.08.2014 Gazette 2014/34)**

(54) **PROCEDE ET DISPOSITIF DE MESURE POUR DES APPLICATIONS DE RESONANCE MAGNETIQUE**

MESSVERFAHREN UND -VORRICHTUNG FÜR MAGNETRESONANZANWENDUNGEN

MEASURING METHOD AND DEVICE FOR MAGNETIC RESONANCE APPLICATIONS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.02.2013 FR 1351285**

(43) Date de publication de la demande:
**23.12.2015 Bulletin 2015/52**

(73) Titulaires:
• **Université Claude Bernard Lyon I**
**69622 Villeurbanne Cedex (FR)**
• **Institut National des Sciences Appliquées de Lyon**
**69621 Villeurbanne Cedex (FR)**
• **Centre National de la Recherche Scientifique**
**75794 Paris Cedex 16 (FR)**
• **Université de Rennes 1**
**35065 Rennes (FR)**

(72) Inventeurs:
• **SAINT-JALMES, Hervé**
**F-35200 Rennes (FR)**
• **BEUF, Olivier**
**F-69250 Montanay (FR)**

(74) Mandataire: **Thibault, Jean-Marc**
**Cabinet Beau de Loménie**
**51, Avenue Jean Jaurès**
**B.P. 7073**
**69301 Lyon Cedex 07 (FR)**

(56) Documents cités:
**US-A- 4 761 612    US-A1- 2012 139 541**

• **BENJAMIN EMANUEL DIETRICH ET AL: "A stand-alone system for concurrent gradient and RF sequence monitoring", PROCEEDINGS OF THE INTERNATIONAL SOCIETY FOR MAGNETIC RESONANCE IN MEDICINE, 20TH ANNUAL MEETING AND EXHIBITION, MELBOURNE, AUSTRALIA, 5-11 MAY 2012, vol. 20, 21 avril 2012 (2012-04-21), page 700, XP055081665,**
• **RUDOLF FRITZ FISCHER ET AL: "Monitoring and compensating phase imperfections in cine balanced steady-state free precession", MAGNETIC RESONANCE IN MEDICINE, 6 février 2013 (2013-02-06), pages n/a-n/a, XP055081664, ISSN: 0740-3194, DOI: 10.1002/mrm.24606**
• **BARMET C ET AL: "Spatiotemporal Magnetic Field Monitoring for MR", MAGNETIC RESONANCE IN MEDICINE, ACADEMIC PRESS, DULUTH, MN, US, vol. 60, 1 juillet 2008 (2008-07-01), pages 187-197, XP002657138, ISSN: 0740-3194, DOI: 10.1002/MRM.21603 [extrait le 2008-06-25]**
• **SIGNE J. VANNESJO ET AL: "Gradient system characterization by impulse response measurements with a dynamic field camera", MAGNETIC RESONANCE IN MEDICINE, vol. 69, no. 2, 12 avril 2012 (2012-04-12), pages 583-593, XP055081659, ISSN: 0740-3194, DOI: 10.1002/mrm.24263**

EP 2 956 786 B1

- JOSEPH P M ET AL: "Electric field measurements in cylindrical imaging coils", JOURNAL OF MAGNETIC RESONANCE, ACADEMIC PRESS, LONDON, GB, vol. 75, no. 2, 1 novembre 1987 (1987-11-01), pages 199-212, XP023960493, ISSN: 0022-2364, DOI: 10.1016/0022-2364(87)90030-8 [extrait le 1987-11-01]
- HOWARD I BASSEN ET AL: "Electric Field Probes-A Review", IEEE TRANSACTIONS ON ANTENNAS AND PROPAGATION, IEEE SERVICE CENTER, PISCATAWAY, NJ, US, vol. AP-31, no. 5, 1 septembre 1983 (1983-09-01), pages 710-718, XP001389022, ISSN: 0018-926X
- SENAJ VILIAM ET AL: "Inductive measurement of magnetic field gradients for magnetic resonance imaging", REVIEW OF SCIENTIFIC INSTRUMENTS, AIP, MELVILLE, NY, US, vol. 69, no. 6, 1 juin 1998 (1998-06-01), pages 2400-2405, XP012036628, ISSN: 0034-6748, DOI: 10.1063/1.1148966

**Description**

La présente invention concerne le domaine technique de la résonance magnétique et en particulier les appareils de RMN (Résonance Magnétique Nucléaire, d'IRM (Imagerie par Résonance Magnétique) et/ou de SRM (Spectroscopie de Résonance Magnétique).

La présente invention concerne plus particulièrement le domaine des instruments ou des dispositifs adaptés pour mesurer les champs électromagnétiques radiofréquences et, les gradients de champ magnétique ainsi que le champ magnétique statique appliqués à un objet à étudier par résonance magnétique.

Les appareils de RMN, d'IRM et/ou de SRM sont des instruments complexes qui mettent en oeuvre des champs magnétiques radiofréquence et des gradients de champ magnétique pour créer des images et/ou des spectres d'une région de l'objet ou du corps à étudier. Ces champs sont créés et organisés au rythme de séquences temporelles dont le chronogramme théorique est décrit dans la littérature pour des familles génériques de séquences.

Toutefois, la variabilité de ces séquences est extrême et dépend des fabricants de ces appareils. Hormis les informations évidentes (temps de répétition, temps d'écho, type de séquence), les détails des séquences utilisées ne sont pas connus. Ainsi, il est bien difficile de connaître précisément les occurrences, les durées et les amplitudes des champs utilisés. Pourtant ces informations sont indispensables à connaître afin de quantifier les signaux recueillis et donc les images obtenues. Outre les champs mentionnés plus haut, la création du champ magnétique radiofréquence d'excitation implique l'existence d'un champ électrique à la même fréquence qui peut être d'amplitude importante et potentiellement dangereux pour le patient. Sa mesure est donc également précieuse. En effet, plus l'intensité du champ magnétique des appareils d'IRM augmente et conséquemment la fréquence de travail, plus le dépôt d'énergie dans le patient s'accroît également. Le respect des limites normatives devient essentiel. La mesure du SAR (Specific Absorption Rate) est ainsi réalisée en continu dans les appareils d'IRM cliniques. A nouveau, le résultat de cette mesure n'est pas directement accessible à l'utilisateur.

Par ailleurs, même lorsque le chronogramme précis de la séquence est bien défini et connu de l'utilisateur de l'appareil, les champs créés ne suivent pas exactement la commande. En effet, diverses imperfections affectent la création de ces champs. L'uniformité spatiale du champ radiofréquence et/ou la linéarité des gradients de champ magnétique sont imparfaites. La commutation des gradients occasionne également la génération de courants de Foucault qui nuisent à la qualité du codage spatial de l'information. De même, les vibrations mécaniques des bobines de gradients ou encore des déséquilibres entre les bobinages de gradients peuvent distordre ce codage spatial. Si les balayages cartésiens du plan de Fourier restent assez résistants à ces imperfections, les balayages non cartésiens (en spirale par exemple) qui sont de plus en plus utilisés pour réduire les temps d'acquisition sont très sensibles à ces défauts. Il devient donc indispensable de mesurer précisément les trajectoires réellement suivies dans le plan de Fourier de l'image lors de ces balayages afin d'en tenir compte pour reconstruire les images. La connaissance de ces trajectoires nécessite à nouveau la mesure des champs magnétiques variables cités ci-dessus.

Pour accéder à ces informations, l'une des méthodes utilisées revient à connecter des instruments de mesure (oscilloscope) dans la salle technique aux différents amplificateurs de radiofréquence et de gradients sur des prises de contrôle prévues à cet effet. Cela suppose d'une part une compétence technique importante et d'autre part la possession d'appareils de mesure et de connecteurs appropriés ainsi que des modalités de connexion. Les gains des différents éléments doivent être fournis par le constructeur de l'appareil. De plus, la mesure des courants ne correspond pas à l'image exacte des champs créés par ces courants dans l'aimant.

Dans l'état de la technique, il est également connu par la publication BENJAMIN EMANUEL DIETRICH ET AL : « A stand-alone system for concurrent gradient and RF sequence monitoring, » PROCEEDINGS OF THE INTERNATIONAL SOCIETY FOR MAGNETIC RESONANCE IN MEDICINE, 20TH ANNUAL MEETING AND EXHIBITION, MELBOURNE, AUSTRALIA, 5-11 MAY 2012, vol. 20, 21 avril 2012, page 700, XP055081665 qu'une partie des champs magnétiques appliqués à l'objet à examiner peut être mesurée et visualisée. Malgré tout dans cette technique, la mesure repose sur le phénomène de RMN et donc chaque capteur contient un échantillon possédant des protons capables de générer un signal de RMN une fois excité. Il s'agit donc d'associer à chaque capteur, un spectromètre RMN complet comprenant des moyens onéreux et complexes d'émission et de réception radiofréquence. Par ailleurs, pour mesurer les gradients de champ magnétique dans les trois directions de l'espace, des capteurs au nombre de six doivent être placés par paire. Ce système de mesure se substitue donc au patient ou objet à examiner. Enfin, la mesure des champs radiofréquence est indirecte et le champ électrique radiofréquence E n'est pas mesuré.

La présente invention vise donc à remédier aux inconvénients de l'art antérieur en proposant un appareil de mesure pour des applications de résonance magnétique, adapté pour mesurer de manière simple et fiable, les champs électromagnétiques radiofréquences et les gradients de champ magnétique réellement appliqués à un objet à examiner par résonance magnétique.

Pour atteindre un tel objectif, la revendication 1 définit un dispositif de mesure pour des applications de résonance magnétique, comportant trois axes de mesures correspondant à l'axe d'un champ magnétique principal et aux deux axes transversaux d'un espace fermé ou semi-ouvert dans lequel sont créés des champs électromagnétiques radiofréquences et des gradients de champ magnétique.

Selon l'invention, le dispositif comporte :

- dans un boîtier de mesure :

  • un capteur de mesure des champs magnétiques radiofréquence comportant un assemblage de bobines radiofréquences pour mesurer les composantes des champs magnétiques radiofréquences selon les deux axes transversaux,
  • un capteur de mesure des gradients de champ magnétique comportant trois ensembles de bobines pour mesurer les gradients de champ magnétique respectivement selon les trois axes de mesure,
  • un capteur de mesure du champ électrique radiofréquence comportant deux fils conducteurs électriques indépendants montés de manière alignée en étant entourés chacun d'un matériau à forte permittivité diélectrique relative,
  • un étage de conditionnement des signaux électriques délivrés par le capteur de mesure des champs magnétiques radiofréquence, par le capteur de mesure des gradients de champ magnétique, par le capteur de mesure du champ électrique radiofréquence,
  • un étage de conversion des signaux électriques délivrés par les différents capteurs de mesure, en des signaux lumineux,
  • une source d'alimentation électrique des étages de conditionnement et de conversion,

- une unité de commande et de traitement des signaux, reliée à l'étage de conditionnement du boîtier de mesure par l'intermédiaire d'un faisceau de transmission des signaux lumineux, cette unité comportant un étage de conversion des signaux lumineux en signaux électriques reliés à des moyens pour piloter en synchronisme, l'acquisition des signaux électriques délivrés par les capteurs de mesure et correspondant aux forces électromotrices créées par les différents champs à l'intérieur de l'espace,
- des moyens d'affichage et/ou d'enregistrement des signaux électriques délivrés par les capteurs.

De plus, le dispositif selon invention peut présenter en outre en combinaison au moins l'un et et/ou l'autre des caractéristiques additionnelles suivantes :

- pour le capteur de mesure du champ électrique radiofréquence, le matériau entourant les fils conducteurs présente une permittivité diélectrique relative > 50,
- les fils conducteurs électriques sont de longueurs sensiblement égales et présentent à leurs extrémités voisines, des bornes de connexion à l'étage de conditionnement,

- pour le capteur de mesure des champs magnétiques radiofréquences, l'assemblage de bobines comporte une bobine plane en forme de papillon et une bobine plane s'étendant parallèlement à la bobine en papillon en étant centrée par rapport à cette dernière,
- un capteur pour mesurer le champ magnétique principal et ses variations comportant deux bobines de type Helmholtz pour mesurer les variations du champ magnétique principal et une cellule à effet Hall pour évaluer le champ magnétique principal en amplitude et direction,
- le capteur pour mesurer les variations du champ magnétique principal comporte deux bobines s'inscrivant dans un cylindre de montage dans lequel s'étendent également les trois ensembles de bobines du capteur de mesure des gradients de champ magnétique, l'assemblage des bobines radiofréquences planes du capteur de mesure des champs magnétiques radiofréquence étant positionné à l'intérieur du cylindre de montage,
- les fils conducteurs électriques du capteur de mesure du champ électrique radiofréquence s'étendent parallèlement à l'axe du cylindre de montage.

Un autre objet de l'invention est de proposer une méthode simple et fiable pour mesurer les champs électromagnétiques radiofréquences et les gradients de champ magnétique réellement appliqués à un objet à examiner par résonance magnétique.

Pour atteindre un tel objectif, la revendication 8 définit un procédé de mesure pour mesurer des champs électromagnétiques radiofréquences et des gradients de champ magnétique engendrés à l'intérieur d'un espace permettant la mise en oeuvre d'applications de résonance magnétique sur un objet, qui consiste :

- à positionner à l'intérieur de l'espace dans lequel l'objet d'étude est placé, le boîtier de l'appareil de mesure selon l'invention, comportant des capteurs de mesure de l'image des champs électromagnétiques radiofréquences et des gradients de champ magnétique appliqués sur l'objet,
- à piloter lors de l'apparition dans les capteurs de l'appareil de mesure, des forces électromotrices créées par les différents champs appliqués sur l'objet, l'acquisition en synchronisme des mesures des capteurs de l'appareil de mesure,
- et à enregistrer et/ou afficher les champs magnétiques radiofréquences, les gradients de champ magnétique et le champ électrique radiofréquence.

De plus, le procédé selon l'invention peut consister en outre en combinaison au moins l'un et et/ou l'autre des caractéristiques additionnelles suivantes :

- à partir de la mesure du champ électrique radiofréquence, à évaluer la dose d'énergie spécifique,
- à partir des mesures réalisées, à réaliser des corrections des images ou des spectres obtenus,
- à corriger par calcul trigonométrique, les valeurs mesurées par les capteurs de mesure pour les replacer dans le repère du champ magnétique principal.

Diverses autres caractéristiques ressortent de la description faite ci-dessous en référence aux dessins annexés qui montrent, à titre d'exemples non limitatifs, des formes de réalisation de l'objet de l'invention.

La **Figure 1** est un schéma de principe d'un appareil de résonance magnétique équipé d'un dispositif de mesure conforme à l'invention.
La **Figure 2** illustre en perspective une forme de réalisation des différents capteurs de mesure d'un boîtier de mesure faisant partie du dispositif de mesure conforme à l'invention.
La **Figure 3** illustre un exemple de réalisation d'un capteur de mesure des champs magnétiques radiofréquences.
Les **Figures 4** à **6** sont des vues en perspective illustrant des bobines pour mesurer des gradients de champ magnétique selon trois axes différents de mesure.
La **Figure 7** est une vue d'un exemple de réalisation d'un capteur de mesure du champ électrique radiofréquence.

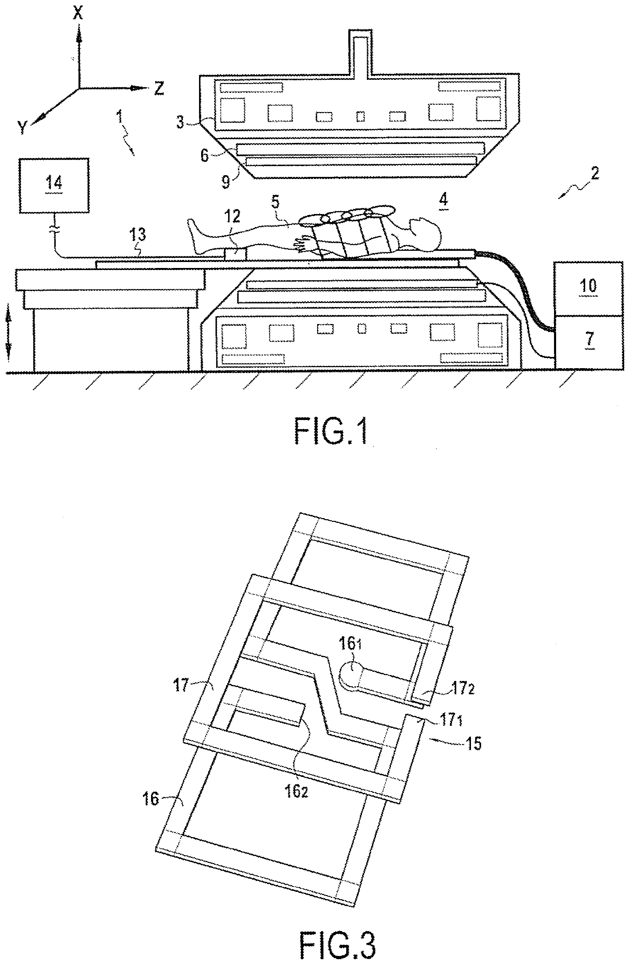

Tel que cela ressort de la **Fig. 1**, l'objet de l'invention concerne un dispositif de mesure **1** pour un appareil de résonance magnétique **2,** de tous types connus en soi, tels que de RMN, d'IRM ou de SRM. De manière classique, l'appareil de résonance magnétique **2** comporte un système d'aimants **3** adapté pour générer un champ magnétique principal statique $B_0$ à l'intérieur d'un espace **4** dans lequel est positionné un objet **5** à examiner, tel un corps humain ou animal.

L'appareil de résonance magnétique **2** comporte également des bobines de gradient **6** alimentées par un bloc d'alimentation **7,** pour générer trois autres champs magnétiques ayant un gradient dans les directions **x, y, z** définissant un système de coordonnées perpendiculaires. Ainsi, à l'intérieur de l'espace **5,** sont créés des gradients de champs magnétiques selon les axes **x, y** et **z.**

L'appareil de résonance magnétique **2** comporte également une ou plusieurs bobines émettrices radiofréquence **9** servant à générer des impulsions **RF** d'excitation magnétique. Cette bobine émettrice radiofréquence **9** est reliée classiquement à un circuit d'émission et à une unité de contrôle **10.**

Cet appareil de résonance magnétique **2** possède une architecture telle que l'espace **4** qui se présente soit sous la forme d'un espace fermé tel un tunnel dont l'axe longitudinal **z** selon lequel l'objet **5** est placé, correspond à l'axe du champ magnétique principal, soit sous la forme d'un espace semi-ouvert à accès transversal dans lequel l'axe **z** du champ magnétique principal est perpendiculaire à l'objet **5.** Le champ $B_1$ magnétique radiofréquence d'émission est perpendiculaire à l'axe du champ magnétique principal $B_0$ et peut donc s'établir selon l'un ou l'autre ou les deux axes transversaux **x** ou **y.** L'appareil de résonance magnétique **2** n'est pas décrit de manière plus détaillée car il est bien connu de l'homme du métier et ne fait pas partie précisément de l'objet de l'invention.

Dans la représentation choisie sur les dessins, la plus commune, l'axe principal de l'objet **5** à examiner est parallèle à l'axe du champ magnétique principal statique $B_0$. Cette disposition conditionne la géométrie des bobines de gradient **6,** des bobines émettrices et réceptrices **9** mais également la géométrie des capteurs conformes à l'invention décrite ci-après. Bien entendu, il existe d'autres configurations d'appareils de résonance magnétique qui créent un champ magnétique qui n'est pas colinéaire à l'axe du patient. Dans ce cas, les géométries sont différentes ainsi que pour les capteurs conformes à l'invention. Toutefois, à partir de la description donnée dans la suite de la description, un homme de l'art est à même de transposer la description de l'invention pour s'adapter à d'autres configurations d'appareils de résonnance magnétique.

Tel que cela ressort plus précisément de la **Fig. 1,** le dispositif de mesure **1** selon l'invention comporte un boîtier de mesure **12** destiné à être placé à l'intérieur de l'espace **4** dans lequel l'objet d'étude **5** est positionné. Ce boîtier de mesure **12** est relié par l'intermédiaire d'un faisceau de transmission **13,** à une unité de commande et de traitement **14** des signaux, située à l'extérieur de l'espace **4.**

Le boîtier de mesure **12** est adapté pour mesurer une image des champs électromagnétiques engendrés à l'intérieur de l'espace **4.**

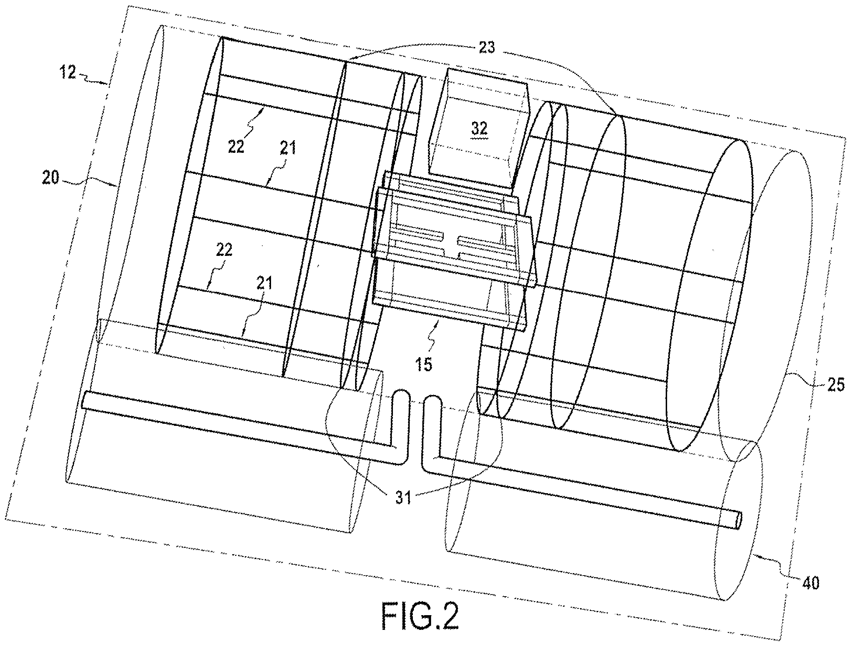

A cet effet, le boîtier de mesure **12** comporte comme illustré aux **Fig. 2** et **3,** un capteur **15** de mesure des champs magnétiques radiofréquences $B_1$ comportant un assemblage de bobines radiofréquences **16, 17** pour mesurer les composantes magnétiques des champs magnétiques radiofréquences selon les deux axes transversaux **x, y** c'est-à-dire dans le plan **x, y** orthogonal à l'axe **z** du champ magnétique $B_0$.

Il est à noter qu'une simple boucle placée dans la bobine d'émission radiofréquence qui crée un champ $B_1$ est le siège d'une force électromotrice e due à la variation de flux :

$$\varphi = B1 \, Cos[\omega \, t] \, S$$

$$e = -\partial_t \, \varphi$$

Pour des champs magnétiques radiofréquences $B_1$ de quelques $\mu T$ et des fréquences de l'ordre de la centaine de MHz ($\omega = 2 \, \pi \, f$), une surface **S** de l'ordre

du cm$^2$ permet de recueillir des dizaines de mV à quelques V de signal radiofréquence. A champ plus faible, le capteur peut présenter plusieurs tours.

Les champs magnétiques radiofréquences **B$_1$** créés sont bien souvent en quadrature de sorte que deux assemblages de bobines **16, 17** permettent donc de recueillir les deux composantes du champ d'émission. De manière à garder une géométrie plane, la mesure en quadrature peut se faire à l'aide d'une boucle en papillon **16**. Ainsi, le capteur de mesure **15** peut comporter une bobine plane double en forme de papillon **16** et une bobine plane **17** s'étendant parallèlement à la bobine double, en étant centrée par rapport à cette dernière. La double bobine plane en forme de papillon **16,** possède une première boucle avec une première borne de connexion **16$_1$** située à une extrémité de cette première boucle et, une deuxième boucle placée à côté et reliée à la première boucle, en présentant une deuxième borne de connexion **16$_2$** à l'extrémité de cette deuxième boucle. La bobine plane **17** est réalisée sous la forme d'une boucle munie à ses deux extrémités placées côte à côte, de deux bornes de connexions **17$_1$, 17$_2$**. Le rapport des surfaces d'une bobine simple et d'une bobine en papillon dépend du volume sondé pour la mesure du champ magnétique radiofréquence **B$_1$**.

La bobine simple **17** et la bobine en papillon **16** sont superposées et parfaitement centrées (sur un circuit double face par exemple) pour éviter toute diaphonie entres les deux mesures. Il peut être envisagé de réaliser les bobines **16**, **17** par trois spires de forme rectangulaire de l'ordre chacune de 1 cm de côté.

Le boîtier de mesure **12** comporte également un capteur de mesure **20** des gradients de champ magnétique. Ce capteur de mesure **20** comporte comme illustré plus particulièrement par les **Fig. 2**, **4**, **5** et **6,** trois ensembles de bobines **21, 22, 23** pour mesurer les gradients de champ magnétique respectivement selon les trois axes de mesure **x, y, z.** Ainsi, trois ensembles de bobines **21, 22, 23** sont réalisés pour couvrir les trois axes **x, y, z.**

La fréquence relativement faible des gradients de champ magnétique impose de multiplier les tours des bobines de mesure pour récupérer suffisamment de tension. Le principe de réciprocité émission-réception est exploité. Les gradients de champ magnétique nécessaires à la localisation spatiale du signal en IRM ou encore à la mesure de coefficients de diffusion en RMN sont créés par des bobinages de géométries connues. Pour mesurer ces gradients de champ, les trois ensembles de bobines sont similaires en réduction aux bobinages de gradients **6**. Le capteur de mesure **20** mesure intrinsèquement un gradient de champ magnétique, de sorte que sa position dans l'espace est arbitraire du moment qu'il est placé dans une région dans laquelle le gradient de champ est créé et que son orientation est correcte.

Selon un exemple de réalisation illustré sur les dessins, le capteur de mesure **20** comporte :

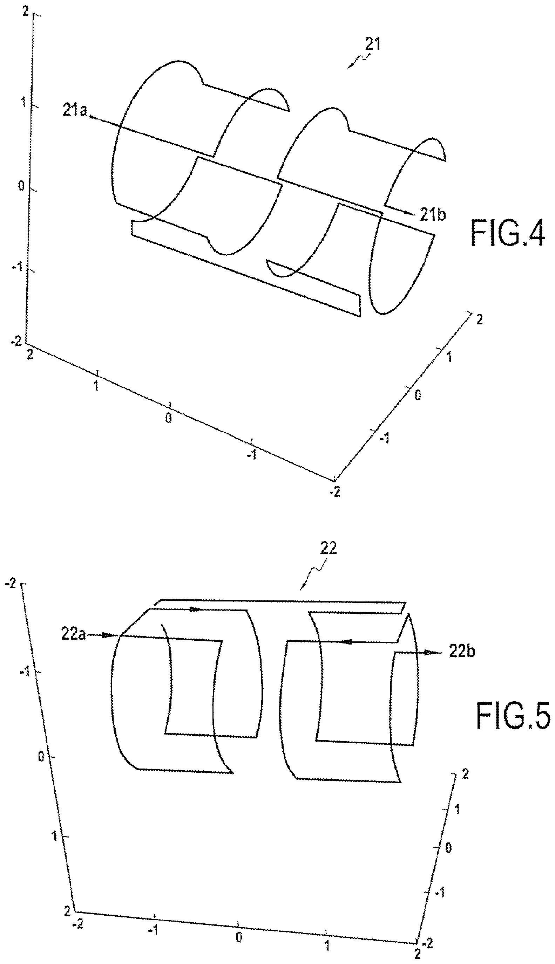

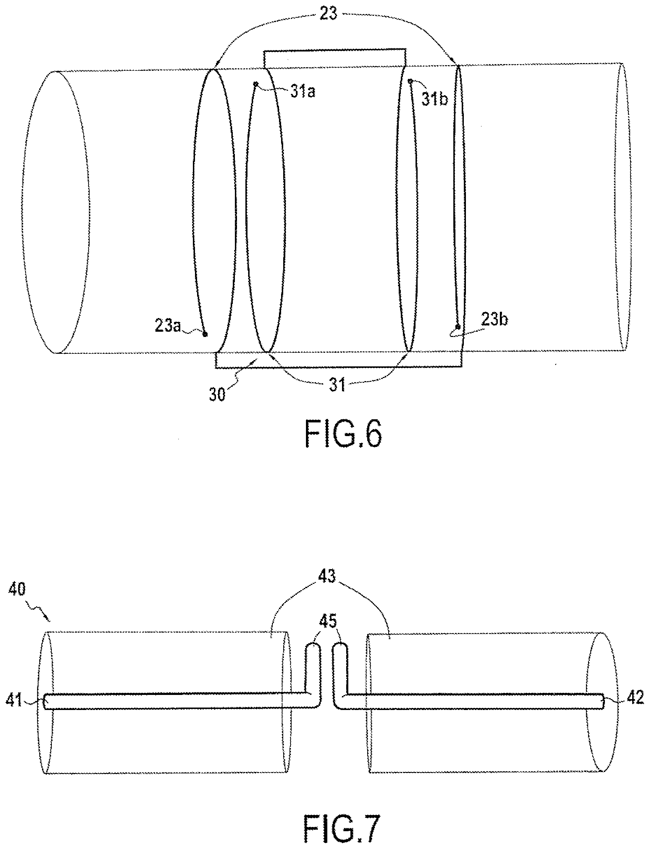

- un premier ensemble de bobines **21** de type GOLAY pour mesurer le gradient dBz/dy selon l'axe **y,** constitué classiquement par deux paires de bobines et présentant des bornes de connexion **21a, 21b (Fig. 4),**
- un deuxième ensemble de bobines **22** de type GOLAY pour mesurer le gradient dBz/dx selon l'axe **x,** constitué classiquement par deux paires de bobines et présentant des bornes de connexion **22a, 22b (Fig. 5),**
- un troisième ensemble de bobines **23** de type MAXWELL pour mesurer le gradient dBz/dz selon l'axe **z** constitué par deux bobines reliées en série et présentant des bornes de connexion **23a, 23b (Fig. 6).**

Selon une variante préférée de réalisation illustrée à la **Fig**. 2, les trois ensembles de bobines **21, 22, 23** sont montées pour s'inscrire dans un cylindre de montage **25**. Avantageusement, l'assemblage des bobines radiofréquences planes du capteur de mesure **15** des champs magnétiques radiofréquences est positionné à l'intérieur du cylindre de montage **25**.

Selon une caractéristique préférée de réalisation, le boîtier de mesure **12** comporte un capteur **30** pour mesurer le champ magnétique principal **B$_0$** et ses variations. Ce capteur **30** comporte ainsi deux bobines de type Helmholtz **31 (Fig. 2** et **6)** pour mesurer les variations du champ magnétique principal **B$_0$** et une cellule **32** à effet Hall pour évaluer le champ magnétique principal **B$_0$** en amplitude et direction. Les deux bobines de type Helmholtz **31** sont montées en série et présentent des bornes de connexions **31a, 31b**. De manière avantageuse, les deux bobines **31** pour mesurer les variations du champ magnétique principal s'inscrivent également dans le cylindre de montage **25**. De même, la cellule à effet Hall **32** est montée à l'intérieur du cylindre de montage **25** et son orientation est définie précisément par rapport à celles des capteurs **15, 20, 30** et **40**. La cellule à effet Hall **32** permet ainsi de mesurer l'amplitude du champ magnétique principal **B$_0$** et donc d'en déduire la fréquence de travail de l'appareil pour adapter l'amplification des signaux provenant des capteurs de mesure **15** et **40** en relation avec leurs fonctions de transfert. Par ailleurs, la connaissance des deux angles (azimut et élévation) de l'ensemble des capteurs de mesure par rapport à l'axe du champ magnétique principal **B$_0$** de l'appareil permet de corriger par un simple calcul trigonométrique les valeurs mesurées par ces capteurs pour les replacer dans le repère du champ magnétique principal **B$_0$** ou de modifier l'alignement de l'ensemble du système de mesure pour l'aligner avec le champ magnétique principal **B$_0$.**

Le boîtier de mesure **12** comporte également un capteur de mesure **40** du champ électrique radiofréquence. Ce capteur **40** mesure les champs électriques engendrés dans l'espace **4** par le champ magnétique radiofréquence créé pour basculer l'aimantation nucléaire. Tel qu'illustré à la **Fig. 7**, ce capteur de mesure **40** comporte deux fils conducteurs électriques indépendants **41**, **42** montés de manière alignée en étant entourés chacun par un matériau à forte permittivité diélectrique relative **43**. Avantageusement, le matériau entourant les fils conducteurs **41**, **42** présente une permittivité diélectrique relative > 50.

Ainsi pour une fréquence du champ électrique donnée, les longueurs d'onde associées :

$$\lambda = \lambda_0/(\varepsilon_r)^{1/2}$$

dans le capteur sont bien plus courtes que celles $\lambda_0$ du champ dans l'air et permettent donc de mesurer efficacement le champ électrique local avec un capteur de dimensions réduites.

Parmi les matériaux à forte permittivité, le plus simple est l'eau dont la permittivité relative est de l'ordre de 80 aux fréquences considérées. L'eau sous forme liquide est difficilement utilisable pour des raisons pratiques évidentes. Il est proposé de gélifier cette eau à l'aide d'agar agar. La solution d'eau et d'agar agar (à quelques pourcents) ainsi que d'une infime quantité de conservateur (NaN3 par exemple) est portée à une température de 80 °C, le refroidissement à température ambiante fournit un gel solide dans lequel sont insérés les conducteurs électriques **41, 42** tels que des brins en cuivre.

Avantageusement, le capteur de mesure **40** est monté dans le boîtier de manière que les fils conducteurs électriques **41, 42** du capteur de mesure du champ électrique radiofréquence s'étendent parallèlement à l'axe du cylindre de montage **25**.

Avantageusement, les fils conducteurs électriques **41, 42** sont de longueurs sensiblement égales. Ces fils conducteurs **41, 42** présentent à leurs extrémités voisines, des bornes de connexion **45**, à un étage de conditionnement non représenté mais intégré à l'intérieur du boîtier **12**.

Cet étage permet de conditionner les signaux électriques délivrés par les différents capteurs de mesure, à savoir par le capteur de mesure **15** des champs magnétiques radiofréquences, par le capteur de mesure **20** des gradients de champ magnétique, par le capteur **30** pour mesurer le champ magnétique principal et ses variations et par le capteur de mesure **40** du champ électrique radiofréquence.

Le boîtier de mesure **12** comporte également un étage de conversion des signaux électriques délivrés par les différents capteurs de mesure **15, 20, 30, 40** en des signaux lumineux. Bien entendu, le boîtier de mesure **12** comporte une source d'alimentation électrique pour les étages de conditionnement et de conversion. A titre d'exemple, le boîtier de mesure **12** présente des dimensions réduites de l'ordre de 12 cm de long, 8 cm de large par 4 cm de haut.

Les signaux lumineux de mesure sont acheminés par l'intermédiaire du faisceau de transmission **13** à l'unité de commande et de traitement **14** sans être soumis à des perturbations liées aux champs créés à l'intérieur de l'espace **4**. L'unité de commande et de traitement **14** est placée en tout endroit adapté en dehors de l'espace **4**.

Cette unité de commande et de traitement **14** comporte un étage de conversion des signaux lumineux en signaux électriques, relié à des moyens pour piloter en synchronisme, l'acquisition des signaux électriques délivrés par les capteurs de mesure.

Il doit être considéré que le boîtier de mesure **12** est passif dans le sens où les mesures sont effectuées uniquement à partir de l'apparition dans l'un et/ou l'autre des capteurs de mesure d'une force électromotrice créée par les différents champs.

Cette unité de commande et de traitement **14** comporte des moyens d'enregistrement et/ou d'affichage des signaux électriques délivrés par les capteurs. Ainsi, cette unité **14** permet d'enregistrer et/ou d'afficher les mesures du champ magnétique radiofréquence, des gradients de champ magnétique selon les trois axes, du champ électrique radiofréquence et/ou du champ magnétique principal et ses variations.

Il ressort de la description qui précède que le dispositif de mesure **1** selon l'invention permet de mesurer de manière homothétique, directement à l'intérieur de l'espace **4** dans lequel l'objet à examiner est positionné, les différents champs créés par un appareil de résonance magnétique **2**.

La mise en oeuvre du dispositif de mesure **1** selon l'invention découle directement de la description qui précède.

Le boîtier de mesure **12** est placé à l'intérieur de l'espace **4**, à proximité par exemple de l'objet **5** à examiner. Il est à noter que la taille réduite du boîtier de mesure **12** permet son positionnement à l'intérieur de l'espace **4** alors que l'objet **5** est également placé à l'intérieur de l'espace **4**.

Il est rappelé que ce boîtier de mesure **12** est passif de sorte qu'une mesure est réalisée uniquement lors du fonctionnement de l'appareil de résonance magnétique **2** qui crée à l'intérieur de l'espace **4**, des champs électromagnétiques radiofréquences et des gradients de champ magnétique.

Lors de la génération de tels champs par l'appareil de résonance magnétique **2**, des forces électromotrices sont créées dans l'un et/ou l'autre des capteurs de mesure du boîtier de mesure **1**. Dès l'apparition d'une force électromotrice, l'unité de commande **14** pilote, en synchronisme, les différents capteurs de mesure du boîtier de mesure **12** afin de mesurer les signaux correspondants selon une base temporelle. Ces différents signaux sont affichés et/ou enregistrés de manière à connaître, par mesure homothétique, les champs magnétiques radiofréquences, les gradients de champ magnétique et le champ électrique radiofréquence.

Ces mesures permettent de déterminer en synchronisme et en temps réel l'ensemble des champs radiofréquence, des gradients de champ magnétique et du champ principal réellement créés dans l'appareil de spectroscopie et/ou d'imagerie par RMN pendant l'examen. Ces informations sont utiles dans de nombreuses applications : lors du développement d'une séquence d'imagerie ou de spectroscopie une société développant ces appareils d'imagerie ou des chercheurs pour décoder la séquence complète des champs utilisés pour créer l'image ou le spectre de RMN recherché et contrôler rapidement et efficacement la bonne mise en oeuvre de la séquence. A partir de la connaissance précise des champs réellement appliqués (balayage effectif de l'espace k, par exemple), il peut être envisagé de réaliser si nécessaire des corrections des images ou des spectres obtenus.

De même, la mesure du champ électrique radiofréquence, permet d'évaluer la dose d'énergie spécifique (DAS ou SAR : Specific Absorption rate) développée par la séquence selon les techniques connues de l'homme du métier.

L'invention n'est pas limitée aux exemples décrits et représentés car diverses modifications peuvent y être apportées sans sortir de son cadre.

## Revendications

1. Dispositif de mesure pour des applications de résonance magnétique, comportant trois axes de mesures **(x, y, z)** correspondant à l'axe **(3)** d'un champ magnétique principal et aux deux axes transversaux **(x, y)** d'un espace fermé ou semi-ouvert **(4)** dans lequel sont créés des champs électromagnétiques radiofréquences et des gradients de champ magnétique, **caractérisé en ce qu'**il comporte :

   - dans un boîtier de mesure **(12) :**

      • un capteur de mesure **(15)** des champs magnétiques radiofréquence comportant un assemblage de bobines radiofréquences **(16, 17)** pour mesurer les composantes des champs magnétiques radiofréquences selon les deux axes transversaux **(x, y),**
      • un capteur de mesure **(20)** des gradients de champ magnétique comportant trois ensembles de bobines **(21, 22, 23)** pour mesurer les gradients de champ magnétique respectivement selon les trois axes de mesure **(x, y, z),**
      • un capteur de mesure **(40)** du champ électrique radiofréquence comportant deux fils conducteurs électriques indépendants **(41, 42)** montés de manière alignée en étant entourés chacun d'un matériau à forte permittivité diélectrique relative **(43),**
      • un étage de conditionnement des signaux électriques délivrés par le capteur de mesure **(15)** des champs magnétiques radiofréquence, par le capteur de mesure **(20)** des gradients de champ magnétique, par le capteur de mesure du champ électrique radiofréquence **(40),**
      • un étage de conversion des signaux électriques délivrés par les différents capteurs de mesure, en des signaux lumineux,
      • une source d'alimentation électrique des étages de conditionnement et de conversion,

   - une unité de commande et de traitement **(14)** des signaux, reliée à l'étage de conditionnement du boîtier de mesure **(12)** par l'intermédiaire d'un faisceau de transmission des signaux lumineux **(13),** cette unité comportant un étage de conversion des signaux lumineux en signaux électriques reliés à des moyens pour piloter en synchronisme, l'acquisition des signaux électriques délivrés par les capteurs de mesure et correspondant aux forces électromotrices créées par les différents champs à l'intérieur de l'espace **(4),**
   - des moyens d'affichage et/ou d'enregistrement des signaux électriques délivrés par les capteurs.

2. Dispositif de mesure selon la revendication 1, **caractérisé en ce que** pour le capteur de mesure du champ électrique radiofréquence **(40),** le matériau **(43)** entourant les fils conducteurs **(41, 42)** présente une permittivité diélectrique relative > 50.

3. Dispositif de mesure selon la revendication 1 ou 2, **caractérisé en ce que** les fils conducteurs électriques **(41, 42)** sont de longueurs sensiblement égales et présentent à leurs extrémités voisines, des bornes **(45)** de connexion à l'étage de conditionnement.

4. Dispositif de mesure selon la revendication 1, **caractérisé en ce que** pour le capteur de mesure **(15)** des champs magnétiques radiofréquence, l'assemblage de bobines comporte une bobine plane en forme de papillon **(16)** et une bobine plane **(17)** s'étendant parallèlement à la bobine en papillon en étant centrée par rapport à cette dernière.

5. Dispositif de mesure selon l'une des revendications 1 à 4, **caractérisé en ce qu'**il comporte un capteur **(30)** pour mesurer le champ magnétique principal et ses variations comportant deux bobines de type Helmholtz **(31)** pour mesurer les variations du champ magnétique principal **(B$_0$)** et une cellule **(32)** à effet Hall pour évaluer le champ magnétique principal **(B$_0$)** en amplitude et direction.

6. Dispositif de mesure selon la revendication 5, **caractérisé en ce que** le capteur **(30)** pour mesurer les variations du champ magnétique principal comporte deux bobines **(31)** s'inscrivant dans un cylindre de montage **(25)** dans lequel s'étendent également les trois ensembles de bobines **(21, 22, 23)** du capteur de mesure **(20)** des gradients de champ magnétique, l'assemblage des bobines radiofréquences planes du capteur de mesure **(15)** des champs magnétiques radiofréquence étant positionné à l'intérieur du cylindre de montage,

7. Dispositif de mesure selon la revendication 6, **caractérisé en ce que** les fils conducteurs électriques **(41, 42)** du capteur de mesure **(40)** du champ électrique radiofréquence s'étendent parallèlement à l'axe du cylindre de montage.

8. Procédé pour mesurer des champs électromagnétiques radiofréquences et des gradients de champ magnétique engendrés à l'intérieur d'un espace **(4)** permettant la mise en oeuvre d'applications de résonance magnétique sur un objet **(5)**, le procédé consistant :

   - à positionner à l'intérieur de l'espace **(4)** dans lequel l'objet d'étude **(5)** est placé, le boîtier **(12)** de l'appareil de mesure **(1)** conforme à la revendication 1, comportant des capteurs de mesure **(15, 20, 40)** de l'image des champs électromagnétiques radiofréquences et des gradients de champ magnétique appliqués sur l'objet **(5)**,
   - à piloter lors de l'apparition dans les capteurs de l'appareil de mesure **(1)**, des forces électromotrices créées par les différents champs appliqués sur l'objet, l'acquisition en synchronisme des mesures des capteurs de l'appareil de mesure,
   - et à enregistrer et/ou afficher les champs magnétiques radiofréquences, les gradients de champ magnétique et le champ électrique radiofréquence.

9. Procédé de mesure selon la revendication 8, **caractérisé en ce qu'**il consiste à partir de la mesure du champ électrique radiofréquence, à évaluer la dose d'énergie spécifique.

10. Procédé de mesure selon la revendication 9, **caractérisé en ce qu'**il consiste à partir des mesures réalisées, à réaliser des corrections des images ou des spectres obtenus.

11. Procédé de mesure selon la revendication 8, **caractérisé en ce qu'**il consiste à corriger par calcul trigonométrique, les valeurs mesurées par les capteurs de mesure pour les replacer dans le repère du champ magnétique principal **(B$_0$)**.

**Patentansprüche**

1. Messvorrichtung für Magnetresonanzanwendungen, umfassend drei Messachsen (x, y, z), die der Achse (3) eines Hauptmagnetfeldes und den beiden Querachsen (x, y) eines geschlossenen oder halb offenen Raumes (4), in dem elektromagnetische Radiofrequenzfelder und Magnetfeldgradienten erzeugt werden, entsprechen, **dadurch gekennzeichnet, dass** sie umfasst:

   - in einem Messgehäuse (12):

     • einen Sensor zur Messung (15) der magnetischen Radiofrequenzfelder, der eine Anordnung von Radiofrequenzspulen (16, 17) umfasst, um die Komponenten der magnetischen Radiofrequenzfelder entlang der beiden Querachsen (x, y) zu messen,
     • einen Sensor zur Messung (20) der Magnetfeldgradienten, der drei Spulenanordnungen (21, 22, 23) umfasst, um die Magnetfeldgradienten jeweils entlang der drei Messachsen (x, y, z) zu messen,
     • einen Sensor zur Messung (40) des elektrischen Radiofrequenzfeldes, der zwei unabhängige elektrische Leitungsdrähte (41, 42) umfasst, die fluchtend angebracht und dabei jeweils von einem Material mit hoher relativer Dielektrizitätskonstante (43) umgeben sind,
     • eine Stufe zum Konditionieren der elektrischen Signale, die durch den Sensor zur Messung (15) der magnetischen Radiofrequenzfelder, durch den Sensor zur Messung (20) der Magnetfeldgradienten, durch den Sensor zur Messung des elektrischen Radiofrequenzfeldes (40) geliefert werden,
     • eine Stufe zum Umwandeln der durch die verschiedenen Messsensoren gelieferten elektrischen Signale in Lichtsignale,
     • eine Quelle zur Stromversorgung der Konditionierungs- und Umwandlungsstufen,

   - eine Einheit zur Steuerung und Verarbeitung (14) der Signale, die mit der Konditionierungsstufe des Messgehäuses (12) mittels eines Lichtsignalübertragungsstrangs (13) verbunden ist, wobei diese Einheit eine Stufe zur Umwandlung der Lichtsignale in elektrische Signale umfasst, die mit Mitteln verbunden ist, um die Erfassung der elektrischen Signale, welche durch die Messsensoren geliefert werden und den durch die verschiedenen Felder innerhalb des Raumes (4) erzeugten elektromotorischen Kräften entsprechen, synchron zu steuern,
   - Mittel zum Anzeigen und/oder Aufzeichnen der durch die Sensoren gelieferten elektrischen Si-

**2.** Messvorrichtung nach Anspruch 1, **dadurch gekennzeichnet, dass** bei dem Sensor zur Messung des elektrischen Radiofrequenzfeldes (40) das die Leitungsdrähte (41, 42) umgebende Material (43) eine relative Dielektrizitätskonstante > 50 aufweist.

**3.** Messvorrichtung nach Anspruch 1 oder 2, **dadurch gekennzeichnet, dass** die elektrischen Leitungsdrähte (41, 42) im Wesentlichen gleiche Längen haben und an ihren benachbarten Enden Anschlüsse (45) zum Anschließen an die Konditionierungsstufe aufweisen.

**4.** Messvorrichtung nach Anspruch 1, **dadurch gekennzeichnet, dass** bei dem Sensor zur Messung (15) der magnetischen Radiofrequenzfelder die Spulenanordnung eine schmetterlingsförmige Flachspule (16) und eine Flachspule (17), die sich parallel zu der schmetterlingsförmigen Spule erstreckt und dabei gegenüber letzterer zentriert ist.

**5.** Messvorrichtung nach einem der Ansprüche 1 bis 4, **dadurch gekennzeichnet, dass** sie einen Sensor (30) zur Messung des Hauptmagnetfeldes und seiner Änderungen umfasst, welcher zwei Spulen vom Typ Helmholtz (31) zum Messen der Änderungen des Hauptmagnetfeldes ($B_0$) und eine Halt-Effekt-Zelle (32) zum Auswerten des Hauptmagnetfeldes ($B_0$) in Amplitude und Richtung umfasst.

**6.** Messvorrichtung nach Anspruch 5, **dadurch gekennzeichnet, dass** der Sensor (30) zur Messung der Änderungen des Hauptmagnetfeldes zwei Spulen (31) umfasst, die sich in einen Montagezylinder (25) einfügen, in dem sich auch die drei Spulenanordnungen (21, 22, 23) des Sensors zur Messung (20) der Magnetfeldgradienten erstrecken, wobei die Anordnung der Radiofrequenzflachspulen des Sensors zur Messung (15) der magnetischen Radiofrequenzfelder innerhalb des Montagezylinders angeordnet ist.

**7.** Messvorrichtung nach Anspruch 6, **dadurch gekennzeichnet, dass** die elektrischen Leitungsdrähte (41, 42) des Sensors zur Messung (40) des elektrischen Radiofrequenzfeldes sich parallel zu der Achse des Montagezylinders erstrecken.

**8.** Verfahren zur Messung von elektromagnetischen Radiofrequenzfeldern und Magnetfeldgradienten, die innerhalb eines Raumes (4) erzeugt werden, der die Durchführung von Magnetresonanzanwendungen an einem Objekt (5) ermöglicht, wobei das Verfahren darin besteht:

- innerhalb des Raumes (4), in dem das Untersuchungsobjekt (5) platziert ist, das Gehäuse (12) des Messgerätes (1) gemäß Anspruch 1, welches Sensoren zur Messung (15, 20, 40) des Bildes der elektromagnetischen Radiofrequenzfelder und der Magnetfeldgradienten, die auf das Objekt (5) angewandt werden, umfasst, zu positionieren,

- während des Auftretens der durch die auf das Objekt angewandten verschiedenen Felder erzeugten elektromotorischen Kräfte in den Sensoren des Messgerätes (1) die synchrone Erfassung der Messungen der Sensoren des Messgerätes zu steuern, und

- die magnetischen Radiofrequenzfelder, die Magnetfeldgradienten und das elektrische Radiofrequenzfeld aufzuzeichnen und/oder anzuzeigen.

**9.** Messverfahren nach Anspruch 8, **dadurch gekennzeichnet, dass** es anhand der Messung des elektrischen Radiofrequenzfeldes darin besteht, die spezifische Energiedosis zu bewerten.

**10.** Messverfahren nach Anspruch 9, **dadurch gekennzeichnet, dass** es anhand der durchgeführten Messungen darin besteht, Korrekturen der erhaltenen Bilder oder Spektren vorzunehmen.

**11.** Messverfahren nach Anspruch 8, **dadurch gekennzeichnet, dass** es darin besteht, mittels trigonometrischer Berechnung die durch die Messsensoren gemessenen Werte zu korrigieren, um sie wieder in dem Koordinatensystem des Hauptmagnetfeldes ($B_0$) zu platzieren.

**Claims**

**1.** A measurement device for magnetic resonance applications, including three measurement axes **(x, y, z)** corresponding to the axis **(3)** of a main magnetic field and to two transverse axes **(x, y)** of a closed or half-open space **(4)** in which are generated radiofrequency electromagnetic fields and magnetic field gradients, **characterized in that** it includes:

- in a measurement case **(12)**:

• a sensor **(15)** for measuring radiofrequency magnetic fields including an assembly of radiofrequency coils **(16, 17)** for measuring the components of the radiofrequency magnetic fields along both transverse axes **(x, y)**,

• a sensor **(20)** for measuring magnetic field gradients including three sets of coils **(21, 22, 23)** for measuring the magnetic field gradients along the three measurement axes **(x, y, z)** respectively,

• a sensor **(40)** for measuring the radiofrequency electric field including two independent electrically conducting wires **(41, 42)** mounted in an aligned way, each being surrounded by a material with strong relative dielectric permittivity **(43),**

• a stage for conditioning the electric signals delivered by the sensor **(15)** for measuring radiofrequency magnetic fields, by the sensor **(20)** for measuring magnetic field gradients, by the sensor for measuring the radiofrequency electric field **(40),**

• a stage for converting the electric signals delivered by the various measurement sensors, into light signals,

• an electric power supply source of the conditioning and conversion stages,

- a unit **(14)** for controlling and processing the signals, connected to the stage for conditioning the measurement case **(12)** via a beam for transmitting light signals **(13),** this unit including a stage for converting light signals into electric signals connected to means for synchronously controlling the acquisition of the electric signals delivered by the measurement sensors and corresponding to the electromotive forces generated by the various fields inside the space **(4),**

- means for displaying and/or recording the electric signals delivered by the sensors.

2. The measurement device according to claim 1, **characterized in that** for the sensor for measuring the radiofrequency electric field **(40),** the material **(43)** surrounding the conductive wires **(41, 42)** has a relative dielectric permittivity >50.

3. The measurement device according to claim 1 or 2, **characterized in that** the electrically conducting wires **(41, 42)** are of substantially equal lengths and have at their neighboring ends, terminals **(45)** for connecting to the conditioning stage.

4. The measurement device according to claim 1, **characterized in that** for the sensor **(15)** for measuring the radiofrequency magnetic fields, the assembly of coils includes a flat coil with a shape of a butterfly **(16)** and a flat coil **(17)** extending parallel to the butterfly-shaped coil while being centred with respect to the latter.

5. The measurement device according to one of claims 1 to 4, **characterized in that** it includes a sensor **(30)** for measuring the main magnetic field and its variations including two coils of the Helmholtz type **(31)** for measuring the variations of the main magnetic field **(B$_0$)** and a Hall Effect cell **(32)** for evaluating the main magnetic field **(B$_0$)** in amplitude and direction.

6. The measurement device according to claim 5, **characterized in that** the sensor **(30)** for measuring the variations of the main magnetic field includes two coils **(31)** included in a mounting cylinder **(25)** in which also extend the three sets of coils **(21, 22, 23)** of the sensor **(20)** for measuring magnetic field gradients, the assembly of the flat radiofrequency coils of the measurement sensor **(15)** for the radiofrequency magnetic fields being positioned inside the mounting cylinder.

7. The measurement device according to claim 6, **characterized in that** the electrically conducting wires **(41, 42)** of the measurement sensor **(40)** for the radiofrequency electric field extend parallel to the axis of the mounting cylinder.

8. A method for measuring radiofrequency electromagnetic fields and magnetic field gradients generated inside a space **(4)** allowing the application of magnetic resonance applications on an object **(5),** the method consisting:

- of positioning inside the space **(4)** in which the object of study **(5)** is placed, the case **(12)** of the measurement apparatus **(1)** according to claim 1, including sensors **(15, 20, 40)** for measuring the image of the radiofrequency electromagnetic fields and of the magnetic field gradients applied on the object **(5),**

- of controlling during the occurrence in the sensors of the measurement apparatus **(1),** electromotive forces generated by the various fields applied on the object, synchronous acquisition of the measurements of the sensors of the measurement apparatus,

- and of recording and/or displaying the radiofrequency magnetic fields, the magnetic field gradients and the radiofrequency electric field.

9. The measurement method according to claim 8, **characterized in that** it consists from the measurement of the radiofrequency electric field, of evaluating the specific energy dose.

10. The measurement method according to claim 9, **characterized in that** it consists from the conducted measurements, of producing corrections of the obtained images or spectra.

11. The measurement method according to claim 8, **characterized in that** it consists of correcting by a trigonometric calculation, the values measured by the measurement sensors in order to replace them in the reference system of the main magnetic field **(B$_0$).**

FIG.1

FIG.3

FIG.2

FIG.4

FIG.5

23

31a      31b

23a      23b

30      31

# FIG.6

40      43

45

41      42

# FIG.7

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **BENJAMIN EMANUEL DIETRICH et al.** A stand-alone system for concurrent gradient and RF sequence monitoring. *PROCEEDINGS OF THE INTERNATIONAL SOCIETY FOR MAGNETIC RESONANCE IN MEDICINE, 20TH ANNUAL MEETING AND EXHIBITION, MELBOURNE,* 21 Avril 2012, vol. 20, 700